# EUROPEAN PATENT APPLICATION

(11) **EP 2 408 013 A1**
(43) Date of publication of application: **18.01.2012**
(21) Application number: 10169688.8
(22) Date of filing: 15.07.2010
(51) Int. Cl.: H01L 31/0352, H01L 31/0304, H01L 31/105, H01L 31/036

(54) **Solid-state structure with quantum dots for photodetection of radiation**

(71) Applicant: Acreo AB, 164 40 Kista (SE)
(72) Inventor: Höglund, Linda, 164 40, KISTA (SE); Gustafsson, Oscar, 113 25, Stockholm (SE)
(74) Representative: Loqvist, Gabriel Mathias

(57) **Abstract**

A solid state-structure and a photodetector comprising the solid-state structure are disclosed. The solid-state structure comprises a carrier (120) and a plurality of quantum dots, QDs (110), distributed in the carrier such that a plurality of QD-carrier interfaces (115) are formed. The carrier (120) comprises a first semiconductor material and at least one of the plurality of QDs (110) comprises a second semiconductor material, wherein the crystal structure of the second semiconductor material is mismatched with respect to the crystal structure of the first semiconductor material such that a QD (110) comprising the second semiconductor material is subjected to tensile strain.

## Description

### Technical field

The present invention generally relates to photodetectors. In particular, the present invention relates to a solid-state structure for photodetection of radiation, and a photodetector comprising the solid-state structure.

### Background

Photodetectors are utilized in a number of applications, e.g. solar energy conversion, thermal imaging, remote gas sensing, medical imaging, communication, remote temperature detection, military night-vision imaging, etc. Photodetectors are known that operate in photoconductive or photovoltaic mode. Photodetectors operating in photoconductive mode are based on photoinduced generation of charge carriers, i.e. electrons, holes or electron-hole pairs or excitons, that give rise to a current that can be detected in the photodetector. Photodetectors operating in photovoltaic mode often require an internal potential barrier with a built-in electric field in order to separate photo-generated electron-hole pairs. Such potential barriers can be created by the use of p-n junctions or Schottky barriers. Whereas the current-voltage characteristics of photoconductive devices are symmetric with respect to the polarity of the applied voltage, photovoltaic devices exhibit rectifying behavior.

Photodetectors may also be classified on the basis of whether photoinduced transitions take place across the fundamental band gap of radiation sensitive material, which transitions may also be referred to as intrinsic transitions, or from impurity states to either of the valence or the conduction band, which transitions may also be referred to as extrinsic transitions.

For detecting radiation in the long-range infrared wavelength range (LWIR), i.e. within a wavelength interval of about 8-15 µm, photodetectors based on a compound of mercury, cadmium and telluride (MCT) are known. MCT based photodetectors may have a relatively high responsivity, i.e. a relatively high electrical output (collected photocurrent) per optical input (incident radiant power). The photodetection process in MCT based devices is based on interband absorption where the energy of absorbed photons is equal to or exceeding the energy band gap of the MCT compound. By changing the composition of the MCT compound, i.e. the relative proportion of Hg, Cd and Te in the compound, and thereby the energy band gap, the MCT based photodetector can be tailored for different cut off wavelengths. A drawback with MCT based photodetectors is difficulty in forming a uniform material. In particular, compositions tailored for LWIR, which require a higher content of mercury, are quite sensitive to heat, making them relatively difficult to fabricate. Since mercury has a relatively large diffusivity, this could possibly entail an enhanced density of defects and, consequently, a relatively nonuniform material. This might particularly entail difficulties in case a relatively large detector array is to be created. In turn, such arrays may be expensive to manufacture.

Another type of photodetector for detecting LWIR is the quantum well (QW) infrared photodetector (QWIP). A QW is a semiconducting layer sandwiched between barrier layers, which causes a quantum confinement effect, i.e. a restriction of electrons and holes in one dimension. The depth of the QW can be designed by changing the composition of the semiconducting material and/or barrier material, and the width can be tailored by changing the thickness of such layers. The absorption in a QWIP is often based on intersubband absorption where the absorption energy equals the energy difference between two subbands within the conduction band (or within the valence band). Intersubband absorption may entail a lower effectiveness compared to interband absorption with regards to photodetector performance. Namely, the responsivity of the QWIP based photodetector may be lower than the responsivity of MCT based photodetectors, and the bandwidth of the detectable wavelength may be smaller. However, a relatively high uniformity of the material of the QWIP may be achieved, which may make QWIPs suitable for producing large detector arrays.

The two different types of photodetectors described in the foregoing, as well as other types of photodetectors, usually require cooling to cryogenic temperatures, e.g., to about 70-80 K, to achieve good performance, or more specifically to suppress dark current. By dark current it is meant a relatively small electric current that flows through a photosensitive device even when no photons are entering the photosensitive device. Thus, dark current implies occurrence of current in the photodetector even in the absence of photons. Dark current has several deleterious effects on the photodetector performance, one of them being a higher noise. Consequently, the presence of dark current has a negative effect on signal-to-noise ratio, and thereby a negative effect on photodetector detectivity. By detectivity it is here meant the normalized radiation power required to cause a photodetector to produce a signal that is equal to the noise, or, put in another way, the reciprocal of the noise-equivalent power (NEP) normalized by the detection area and noise bandwidth, where NEP is the minimum optical power that can be detected. For achieving the required performance of the photodetector, cooling of the photodetector to a relatively low operating temperature is often required, at which operating temperature the performance of the photodevice is relatively unaffected by dark current. Cooling of the photodetector is a costly and/or complex process, and, consequently, effort has been made to increase the operating temperature of photodetectors at which acceptable performance can be achieved.

### Summary

It is with respect to the above considerations and others that the present invention has been made. The present invention seeks to mitigate, alleviate or eliminate one or more of the above-mentioned deficiencies and disadvantages singly or in combination. In particular, it would be desirable to achieve a solid-state structure for photodetection of radiation that is capable of enabling a relatively high operating temperature.

To achieve this, a solid-state structure having the features as defined in the independent claim is provided. Further advantageous embodiments of the present invention are defined in the dependent claims.

As well known in the field of semiconductors, there are different types of charge carriers, one of them being electrons. Another type of charge carrier is the so called hole, i.e. a traveling vacancy in the electron population of the valence band. Holes may carry positive charge. In other words, in the context of the present application by the wording "hole" it is meant the absence of an electron in an otherwise full electron 'shell'.

A common feature of both semiconductors and insulators is an energy 'band gap'. The energy band gap (or simply "band gap" in the following) is the energy difference between a highest energy level occupied by electrons and a lowest energy level void of electrons. In general, semiconductors have a relatively small band gap in comparison to insulators. In an inorganic semiconductor or insulator, this energy difference is the difference between the valence band edge ('top' of the valence band) and the conduction band edge ('bottom' of the conduction band). In a substantially or even completely pure material, the energy band gap is devoid of energy states where electrons and holes can exist, and the available charge carriers are electrons and holes whose energy is sufficient for excitation across the band gap.

In terms of an energy band model, excitation of a valence band electron into the conduction band creates charge carriers. That is, electrons are charge carriers when on the conduction-band side of the band gap, and holes are charge carriers when on the valence-band side of the band gap.

As described in the foregoing, a QW is a semiconducting layer sandwiched between barrier layers, which causes a quantum confinement effect so as to restrict electrons and holes in one dimension. Other quantum confining structures are quantum wires and quantum dots (QDs). Quantum wires provide a two-dimensional restriction of charge carriers, whereas QDs restrict charge carriers - electrons, holes and/or excitons - in three dimensions to discrete quantum energy states.

According to a first aspect of the present invention, there is provided a solid-state structure comprising a carrier and a plurality of QDs. The plurality of QDs are distributed in the carrier such that a plurality of QD-carrier interfaces are formed. The carrier comprises a first semiconductor material. At least one of the plurality of QDs comprises a second semiconductor material, wherein the crystal structure of the second semiconductor material is mismatched with respect to the crystal structure of the first semiconductor material such that a QD comprising the second semiconductor material is subjected to tensile strain.

Thus, the present invention is based on the use of QDs in a solid-state structure particularly intended to be utilized in photodetector device, wherein a plurality of QDs are embedded in a carrier or bulk material, and the second semiconductor material of at least one of the QDs and the first semiconductor material of the carrier, respectively, have been selected such that a QD comprising the second semiconductor material is subjected to tensile strain.

Where the QD and the carrier on the sides of the respective QD-carrier interface comprise semiconductor materials having unequal energy band gaps, heterojunctions can be formed.

In the context of the present application, by energy levels for "heavy holes" and "light holes" it is meant the energy levels converging at valence band maximum in the Brillouin zone centre, e.g, at the gamma (Γ)-point. By "heavy" and "light" it is referred to the curvature of the respective energy level in energy-momentum space being relatively flat and steep, respectively, which corresponds to a higher effective mass and a lower effective mass, respectively.

When the QDs in the solid-state structure are subjected to compressive or tensile strain, the electronic energy levels or bands for heavy holes (HHs) and light holes (LH) split up.

When a QD is subjected to compressive strain, both the energy levels of the HHs and the energy levels of the conduction band may be shifted towards higher energies. A difference between energy levels of the HHs and energy levels of the conduction band depends on the choice of semiconductor materials in the QDs and the carrier, respectively.

When a QD is subjected to tensile strain, the energy levels of the LHs may be shifted towards higher energies whereas the energy levels of the conduction band may be shifted towards lower energies, and hence possibly result in an effective decrease in band gap in the QD.

In the case where a QD is subjected to tensile strain, due to increased energy levels of the LHs a difference between energy levels of QD LHs and energy levels of the conduction band of the carrier may decrease. Also due to increased energy levels of the LHs, the LHs may effectively define the valence band in the QD.

Due to the carrier typically having a significantly larger volume compared to the volume of the QDs distributed in the carrier, the carrier can in the context of the application be considered as being subjected to only a relatively low or even a negligible degree of strain.

In general, by subjecting a QD to tensile strain the electronic energy levels of HHs and LHs may become split to a greater extent compared to when the QD is subjected to compressive strain. Thus, subjecting a QD to tensile strain may entail a reduced interaction between LH energy bands and HH energy bands compared to when the QD is subjected to compressive strain. In turn, by reducing the interaction between LH energy bands and HH energy bands, Auger processes, or Auger charge carrier recombination processes, may be suppressed, which in turn may decrease or suppress dark current.

By means of subjecting a QD to tensile strain, e.g., by appropriately selecting the first and/or second secmiconductor material (discussed in more detail in the following), the energy levels of QD LHs may be shifted so as to enable at least some junctions between QD and carrier, respectively, to exhibit a type II electronic energy level alignment, having an energy band gap between a valence band energy level situated in a QD subjected to tensile strain and energy of a conduction band energy level situated in the carrier appropriate for photodetection of radiation within selected wavelength ranges, e.g. 3-5 µm, 8-14 µm, and 100-1000 µm. At the same time, Auger processes may be suppressed, which may decrease dark current, as discussed in the foregoing.

By selecting the first semiconductor material of the carrier such that the first semiconductor material has a larger band gap than the optical transition energy corresponding to the wavelength of the detected photons, generation-recombination (GR) current and/or band-to-band tunneling or regeneration generated currents may be suppressed, which, in turn, may increase charge carrier lifetime and/or reduce dark current and/or noise. A significant contribution to GR current generally arises from GR via vacant trap levels or states in a depletion region, i.e. Shockley-Read-Hall (SRH) charge carrier recombination.

Given a required performance of the solid-state structure and/or photodetector, such a reduction of dark current may in turn entail an increased operating temperature of the solid-state structure or photodetector, respectively, in particular in comparison to MCT based photodetectors or QWIPs.

Although the Applicant does not wish to be bound by any theory, it is contemplated that a solid-state structure and/or photodetector according to the present invention may enable an operating temperature approaching 200 K or even higher. Such temperatures may be attainable by means of, e.g., thermoelectric cooling. Thus, cooling to cryogenic temperatures, e.g., to about 70-80 K, to achieve required performance in photodetectors, or more specifically to suppress dark current, may hence not be required. Thus, cryogenic coolers and assemblies may not be required.

As the LHs have a relatively low effective mass, there may be an increased probability of an LH quantum tunneling through a surrounding potential or energy barrier. Therefore, the overlap of the quantum mechnical wave function of the LH and the quantum mechnical wave function of the electron of the respective electron-hole pair may increase, which may entail an increased probability for absorbing a photon.

The increased probability of a LH quantum tunneling through a surrounding energy barrier, and the fact that LHs have a higher mobility than HHs, due to the lower effective mass of the LHs, may entail an increased contribution to the diffusion current from the holes. The diffusion current is normally dominated by excited electrons moving by means of diffusion in the carrier. In turn, this may entail an increased responsivity of the solid-state structure and/or of a photodetector comprising the solid-state structure.

For example by changing the composition of the second semiconductor material, i.e. the relative proportion of the substances or elements comprised in the second semiconductor material, and thereby the energy band gap between energy of a hole situated in a QD subjected to tensile strain and energy of an electron situated in the carrier, the solid-state structure or photodetector can be tailored for different cut off wavelengths, i.e. for different detection wavelengths or detection wavelength ranges at which detection may be performed.

For example where the second semiconductor material comprises GaSbₓAs₁₋ₓ, where x>0, the cut off wavelength can be tailored between wavelengths in the mid-range infrared wavelength range (MWIR), i.e. within a wavelength interval of about 3-5 µm, LWIR, and so called terahertz (THz) radiation, i.e. electromagnetic waves at frequencies in the terahertz range, by changing the amount of Sb in the second semiconductor material.

The choice of the second semiconductor material is not limited to GaSbₓAs₁₋ₓ, where x>0, provided by way of example. This is described further in the following.

A solid-state structure according to the first aspect of the present invention may operate in photoconductive or photovoltaic mode.

A solid-state structure according to the first aspect of the present invention or any embodiment thereof may be arranged as a pixel element. A plurality of such pixel elements can be arranged so as to form an array of pixels that can be utilized to achieve, or constitute on their own, a photodetector. Such a photodetector can for example be employed in an infrared camera.

Hence, according to a second aspect of the present invention there is provided a photodetector comprising a solid-state structure according to the first aspect of the present invention or any embodiment thereof.

At least some junctions between QD and carrier, respectively, may exhibit a type II electronic energy level alignment or a so called staggered band gap type heterojunction. Such a configuration can increase the spatial separation between charge carriers of different types (e.g., holes and electrons), which in turn may enable increasing charge carrier lifetime.

As known in the art, by staggered band gap type heterojunction it is meant a semiconductor heterojunction where in terms of an energy band model the semiconductor materials on both sides of the junction have unequal band gaps and the alignment between conduction band and valence band is staggered so that electrons and holes are confined in different spaces.

A type II electronic energy level alignment for at least some junctions between QD and carrier may enable interband absorption in MWIR, LWIR or THz range with a relatively high responsivity and a relatively wide bandwidth, provided that the configuration of the solid-state structure has been appropriately selected, for example by changing the composition of the second semiconductor material as described above.

The charge carriers may comprise electron-hole pairs. An electron-hole pair may comprise a hole situated in a QD and an electron situated in the carrier.

However, the present invention is not necessarily limited to this case. Although the Applicant does not wish to be bound by any theory, it is contemplated that an electron-hole pair may comprise a hole situated in the carrier and an electron situated in a QD.

The first semiconductor material and the second semiconductor material may be selected such that the value of an energy band gap between energy of a hole situated in a QD subjected to tensile strain and energy of an electron situated in the carrier is comprised in an interval between about 0 eV and 0.4 eV.

Hence, the first semiconductor material and the second semiconductor material may be selected such that radiation comprising radiation within a wavelength range of about 3 µm to about 1 mm incident on the solid-state structure causes generation of charge carriers.

The first semiconductor material and/or the second semiconductor material may be based on a compound from the group of III-V semiconductors.

The second semiconductor material may for example comprise a compound comprising gallium (Ga) and arsenide (As). The compound may further comprise antimony (Sb), aluminum (AI), nitrogen (N), germanium (Ge), tin (Sn), bismuth (Bi) or any combination thereof.

The first semiconductor material may for example comprise a compound comprising indium (In) and As.

The carrier comprising the first semiconductor material may hence for example comprise InAs. The carrier may be grown by means of, e.g., an InAs substrate acting as seed crystal. A compound comprising In and As, such as InAs, generally allows for relatively easy fabrication with a relatively high yield and a finished material having a relatively good uniformity. This may entail a less expensive procedure for forming or manufacturing the carrier as compared to, e.g., MCT based devices, for achieving the same or similar photodetecting performance.

The crystal structure of the second semiconductor material may be mismatched with respect to the crystal structure of the first semiconductor material such that the lattice of the second crystal structure has at least one lattice parameter that is different from at least one lattice parameter of the lattice of the first crystal structure.

In other words, mismatch of the crystal structure of the second semiconductor material with respect to the crystal structure of the first semiconductor material, or vice versa, may be with regards to at least one lattice parameter of one of the crystal structures.

The at least one lattice parameter of the lattice of the second crystal structure may differ from the at least one lattice parameter of the lattice of the first crystal structure by at least 2%.

According to one specific example, the at least one lattice parameter of the lattice of the second crystal structure differs from the at least one lattice parameter of the lattice of the first crystal structure by between 2% and 10%.

According to another example, the QD subjected to tensile strain may be subjected to tensile strain in at least two directions relatively to at least a portion of the respective QD-carrier interface.

For example, the QD subjected to tensile strain may be subjected to tensile strain in at least two directions perpendicular to a longitudinal direction of the carrier.

According to one example, the longitudinal direction of the carrier may be a direction that is parallel to the crystallographic direction in which the carrier has been grown during formation of the carrier, e.g., a direction perpendicular to one of the (001) planes, in case the material of the carrier exhibits a cubic crystal structure.

For example, the carrier may be grown on a substrate by means of epitaxy, where the substrate acts as a so called seed crystal so that the carrier adopts the crystal structure and orientation of the substrate. The substrate may hence for example be configured such that the growth direction of the carrier is perpendicular to a certain crystallographic plane. In a case where the substrate has a cubic crystal structure, the growth direction may hence for example be parallel to the [001] direction. The tensile strain to which a QD is subjected may hence be biaxial in a plane perpendicular to the growth direction, e.g. in the (001) plane.

Radiation incident on the solid-state structure of the photodetector can cause generation of charge carriers. In this way, charge carriers become excited and may move about in the carrier.

The photodetector may comprise at least one electrical contact layer electrically coupled to the carrier. Such a configuration may enable collecting excited charge carriers, e.g., electrons, moving by means of diffusion in the carrier until they are collected by the electrical contact layer.

According to another example, the photodetector comprises at least two electrical contact layers electrically coupled to the carrier.

In this case, a first electrical contact layer can be electrically coupled to a first end of the carrier and a second electrical contact layer can be electrically coupled to a second end of the carrier. Such a configuration may enable collecting excited charge carriers by means of drift. That is, an electrical field generated between the electrical contact layers may induce a drift velocity of the charge carriers.

Thus, the photodetector may comprise an electrical field generator adapted to selectively generate an electrical field between the first and second electrical contact layers.

In the context of the present application and in relation to electrical components electrically coupled or connected to each other, the term coupled, or electrically coupled, is not limited to be construed as directly coupled, or directly electrically coupled, but also encompasses functional connections having intermediate components. For example, on one hand, if an output of a first component is connected to an input of a second component, this comprises a direct connection or coupling. On the other hand, if an electrical conductor directly supplies an electrical signal from the output of the first component substantially unchanged to the input of the second component, alternatively via one or more additional components, the first and second component are also connected. However, the connection is functional in the sense that a gradual or sudden change in the electrical signal from the output of the first component results in a corresponding or modified change in the signal that is input to the second component.

Thus, an electrical contact layer being electrically connected to an end of the carrier does not necessarily mean that the electrical contact layer is directly connected to or arranged on the carrier.

The first semiconductor material, the second semiconductor material and/or the material of an electrical contact layer may be doped.

In the context of some embodiments of the present application, by lattice parameters it is meant the set of distances between unit cells in the crystal structure, i.e. the lattice 'constants', and the three angles between the lattice constants.

In the context of some embodiments of the present application, by the wording "longitudinal direction" of an element it is meant a direction parallel to a length of the element.

The present invention relates to all possible combinations of features recited in the claims.

Further objects and advantages of the various embodiments of the present invention will be described below by means of exemplifying embodiments.

### Brief description of the drawings

Exemplifying embodiments of the invention will be described below with reference to the accompanying drawings, in which:
Fig. 1 is a schematic cross-sectional view of a photodetector according to an embodiment of the present invention;
Fig. 2 is a schematic energy band diagram of a portion of a solid-state structure according to an embodiment of the present invention; and
Fig. 3 is a schematic energy band diagram of a portion of a photodetector according to an embodiment of the present invention.

In the accompanying drawings, the same reference numerals denote the same or similar elements throughout the views.

### Detailed description

The present invention will now be described more fully hereinafter with reference to the accompanying drawings, in which exemplifying embodiments of the invention are shown. This invention may however be embodied in many different forms and should not be construed as limited to the embodiments set forth herein; rather, these embodiments are provided by way of example so that this disclosure will convey the scope of the invention to those skilled in the art. Furthermore, like numbers refer to like or similar elements throughout.

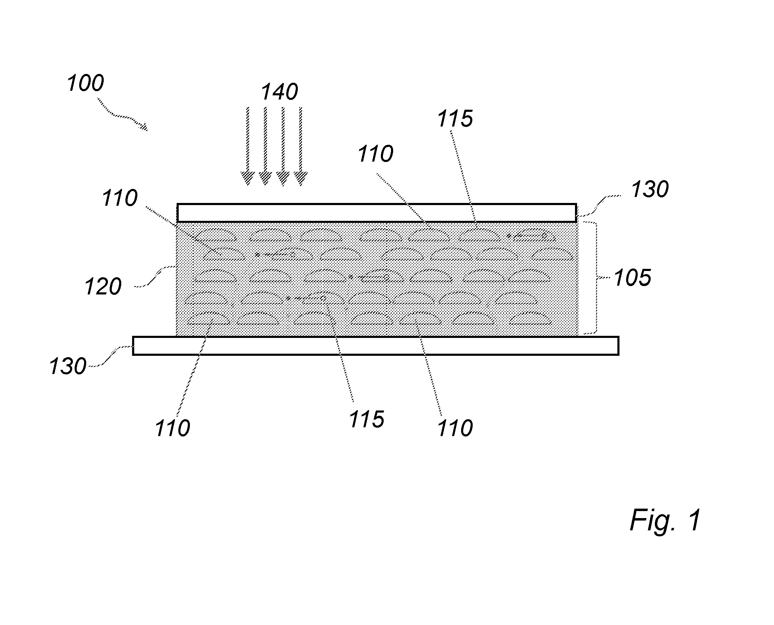

Referring now to Fig. 1, there is shown a schematic cross-sectional view of a photodetector 100 according to an embodiment of the present invention. The photodetector 100 comprises a solid-state structure 105. The solid-state structure 105 comprises a plurality of QDs 110 (of which only a few are indicated by a reference numeral 110 in Fig. 1) embedded or distributed in a carrier 120 such that a plurality of QD-carrier interfaces 115 are formed (of which only a few are indicated by a reference numeral 115 in Fig. 1).

According to the embodiment depicted in Fig. 1, the carrier 120 comprises InAs and at least some of the QDs comprise GaAsSb. By this choice of semiconducting materials for the carrier 120 and the QDs 110, respectively, the crystal structure of a QD comprising GaAsSb is mismatched with respect to the crystal structure of the carrier comprising InAs such that the QD comprising GaAsSb is subjected to tensile strain. According to the embodiment depicted in Fig. 1, the mismatch of the crystal structure of a QD comprising GaAsSb with respect to the crystal structure of the carrier comprising InAs is such that the lattice of the crystal structure of a QD comprising GaAsSb has at least one lattice parameter that is different from at least one lattice parameter of the lattice of the crystal structure of the carrier comprising InAs.

The at least one lattice parameter of the crystal structure of a QD comprising second semiconductor material may in one example differ from the at least one lattice parameter of the lattice of the crystal structure of the carrier comprising first semiconductor material by between 2% and 10%. However, deviation from this range of percentages is contemplated, e.g. down to 1%, and/or up to 12%.

In accordance with the embodiment illustrated in Fig. 1, a QD 110 may exhibit a lens-like shape having a substantially plane surface and a substantially convex surface with respect to the interior of the QD. Such a QD 110 typically has a diameter of about 20 nm and a height of about 2 nm. In a portion of a plane perpendicular to a longitudinal direction of the carrier there may typically be about 1000 QDs for a portion having a surface area of about 1 µm²_{.}

The present invention is not limited to the shape of the QDs as illustrated in Fig. 1, provided by way of example. In practice, the shape of the QDs may depend at least partially upon the choice of fabrication technique of the solid-state structure. For example, inorganic QDs in an inorganic carrier may be created using an epitaxial method often called Stranski-Krastanov growth (sometimes referred to as the self-assembled quantum dot (SAQD) technique). This method creates a lattice-mismatch induced strain between the QDs and the bulk or seed matrix (not shown in Fig. 1) while reducing lattice damage and defects. However, other methods for fabrication of the solid-state structure can be used.

According to the embodiment depicted in Fig. 1, the substrate on which the carrier and the QDs have been grown (substrate not shown in Fig. 1), so that the carrier adopts the crystal structure and orientation of the substrate, have been configured such that the growth direction of the carrier is perpendicular to the (001) crystallographic plane. In this example, the tensile strain to which a QD comprising GaAsSb is subjected is biaxial in the 'growth plane' of the carrier/solid-state structure, i.e. in the (001) plane.

With further reference to Fig. 1, the photodetector 100 comprises two electrical contact layers 130 between which the solid-state structure 105 is sandwiched. Radiation 140 within a wavelength range incident on the solid-state structure 105 of the photodetector 100 causes generation of charge carriers in the solid-state structure 105. In this case, the charge carriers comprise electron-hole pairs, wherein an electron-hole pair comprises a hole (indicated by unfilled circles in Fig. 1) situated in a QD 110 and an electron (indicated by filled circles in Fig. 1) situated in the carrier 120. As indicated in Fig. 1, the charge carriers in the carrier 120, i.e. electrons, become excited and may move about in the carrier 120, e.g., by means of diffusion.

By means of at least one of the electrical contact layers 130 the excited charge carriers moving by means of diffusion in the carrier can be collected.

Alternatively or optionally, an electrical field generated between the two electrical contact layers 130 may induce a drift velocity of the charge carriers in the carrier 120. In this manner, excited charge carriers may be collected at an electrical contact layer 130 by means of drift.

Notwithstanding how the charge carriers in the carrier 120 are collected, the current induced by the excited charge carriers may then be detected.

For example, in accordance with the embodiment depicted in Fig. 1 the current induced by the excited charge carriers may be rectified at a p-n junction, e.g. comprising the electrical contact layers 130, and subsequently detected by means of a current sensor (not shown in Fig. 1).

Any electrical contact layer may for example comprise a doped semiconductor material having a crystal structure whose lattice is matched to the lattice of the crystal structure of adjacent components.

The photodetector may comprise additional components (not shown in Fig. 1), e.g., metallic contacts, electrical wiring, etc.

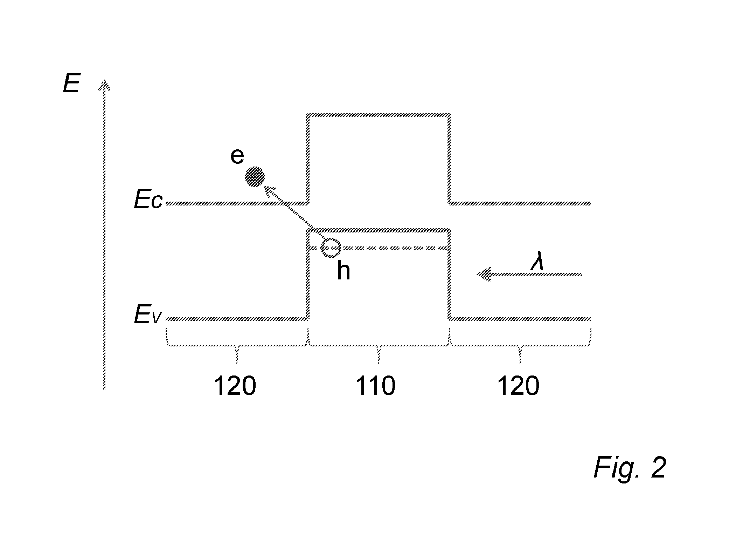

Referring now to Fig. 2, there is shown a schematic energy band diagram of a portion of the solid-state structure 105 described with reference to Fig. 1, where the energy *E* is given in arbitrary units (relative some reference energy). Specifically, Fig. 2 is an energy band diagram of a portion of the solid-state structure 105 comprising carrier material, indicated by the reference numeral 120, and a QD, indicated by the reference numeral 110.

Radiation within a wavelength range, which radiation is indicated by "λ" in Fig. 2, causes the excitation of an electron e in the valence band of a QD 110 comprising GaAsSb into the conduction band of the carrier 120 comprising InAs, leaving a hole h in the valence band of the QD 110. The conduction band edge and the valence band edge have energies E_{c} and Eᵥ, respectively. That is, E_{c} represents the lowest possible energy in the conduction energy band and Eᵥ represents the highest possible energy in the valence band.

The interband transition illustrated in Fig. 2 creates a hole in the initial state and excites an electron to the final state, and may be considered as the creation of an electron-hole pair.

The dashed line in Fig. 2 indicates a bound LH state.

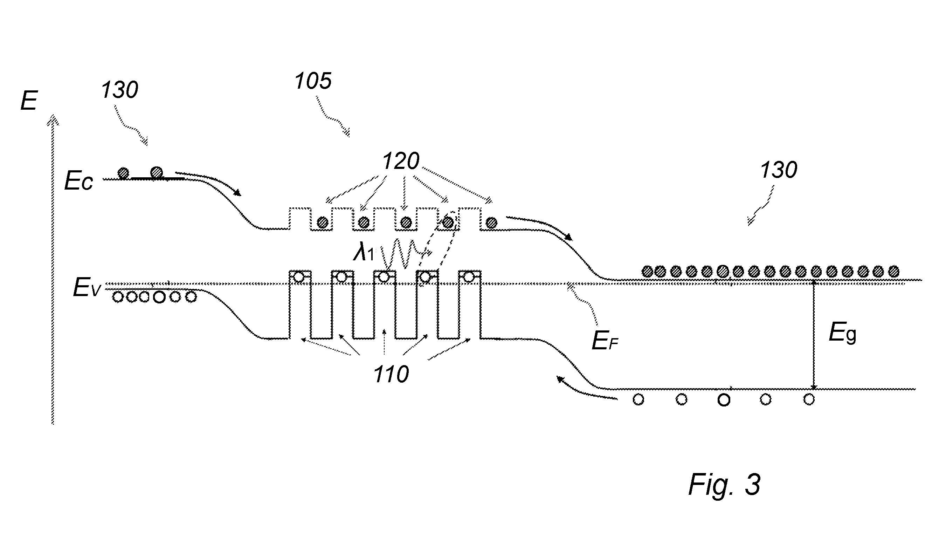

Referring now to Fig. 3, there is shown a schematic energy band diagram of a portion of a photodetector according to an embodiment of the present invention. Specifically, Fig. 3 is an energy band diagram of a portion of the photodetector comprising electric contact layers, indicated by the reference numerals 130, and a solid-state structure 105 comprising carrier material, indicated by the reference numeral 120, and a plurality of QDs, indicated by the reference numeral 110.

According to the embodiment depicted in Fig. 3, at least some of the QDs 110 comprise GaAsSb, and the carrier 120 comprises InAs.

Similarly to the band energy diagram shown in Fig. 2, in Fig. 3 E_{c} represents the lowest possible energy in the conduction energy band and Eᵥ represents the highest possible energy in the valence band. Holes are indicated by unfilled circles, and electrons are indicated by filled circles. The dashed line (ellipse) in Fig. 3 indicates photoinduced generation of an electron-hole pair. The lowermost dotted line represents the Fermi level *E*_{F}. Eg represents the energy band gap in the electrical contact layer 130 on the right-hand side in Fig. 3.

As indicated in Fig. 3, the electrical contact layer 130 on the left-hand side in Fig. 3 is p-doped by having an abundance of holes, and the electrical contact layer 130 on the right-hand side in Fig. 3 is n-doped by having an abundance of electrons. The number of electrons in the conduction band depends on temperature, doping, etc.

The energy band diagram depicted in Fig. 3 illustrates the situation where the respective QD 110 is subjected to tensile strain, such as discussed in the foregoing. The uppermost dotted line in Fig. 3 represents the conduction band in the QDs 110, which represents a local energy barrier or potential for electrons, about which energy barrier or potential the electrons may move (cf. Fig. 1, where excited electrons move about in the carrier 120, e.g., by means of diffusion). Below the QD 110 conduction band in Fig. 3 are the energy levels of the QD 110 LHs, which energy levels in this example at least partly constitute the valence band in the respective QD 110.

Fig. 3 depicts the portion of the photodetector being in a state of equilibrium, e.g., equilibrium between the drift current and the diffusion current - indicated by *E_{F}* being constant throughout the portion of the photodetector.

As indicated in Fig. 3, electromagnetic radiation having a wavelength λ₁ incident on the photodetector, and hence on the solid-state structure 105, causes the excitation of an electron in the valence band of a QD 110 comprising the second semiconductor material, such as GaAsSb, into the conduction band of the carrier 120 comprising the first semiconductor material, such as InAs, leaving a hole in the valence band of the QD 110. According to one example λ₁ is about 8.5 µm.

The material of the electrical contact layers 130 can be selected such that the electrical contact layers 130 absorb at another radiation wavelength range as compared to the solid-state structure 105.

Although exemplary embodiments of the present invention have been described herein, it should be apparent to those having ordinary skill in the art that a number of changes, modifications or alterations to the invention as described herein may be made. Thus, the above description of the various embodiments of the present invention and the accompanying drawings are to be regarded as non-limiting examples of the invention and the scope of protection is defined by the appended claims. Any reference signs in the claims should not be construed as limiting the scope.

## Claims

1. A solid-state structure (105) for photodetection of radiation (140), the solid-state structure comprising:
a carrier (120); and
a plurality of quantum dots, QDs (110), distributed in the carrier such that a plurality of QD-carrier interfaces (115) are formed;
the carrier comprising a first semiconductor material and at least one of the plurality of QDs comprising a second semiconductor material, wherein the crystal structure of the second semiconductor material is mismatched with respect to the crystal structure of the first semiconductor material such that a QD comprising the second semiconductor material is subjected to tensile strain.

2. A solid-state structure according to claim 1, wherein at least some junctions between QD and carrier, respectively, exhibit a type II electronic energy level alignment.

3. A solid-state structure according to claim 1 or 2, wherein the charge carriers comprise electron-hole pairs, wherein an electron-hole pair comprises a hole (h) situated in a QD and an electron (e) situated in the carrier or a hole situated in the carrier and an electron situated in a QD.

4. A solid-state structure according to claim 3, wherein the first semiconductor material and the second semiconductor material are selected such that the value of an energy band gap between energy of a hole situated in a QD subjected to tensile strain and energy of an electron situated in the carrier is comprised in an interval between about 0 eV and 0.4 eV.

5. A solid-state structure according to any one of claims 1-4, wherein the first semiconductor material and the second semiconductor material are selected such that radiation comprising radiation within a wavelength range of about 3 µm to about 1 mm incident on the solid-state structure causes generation of charge carriers.

6. A solid-state structure according to any one of claims 1-5, wherein the first and/or the second semiconductor material is based on a compound from the group of III-V semiconductors.

7. A solid-state structure according to claim 6, wherein the second semiconductor material is a compound comprising gallium and arsenide.

8. A solid-state structure according to claim 6 or 7, wherein the second semiconductor material further comprises antimony, aluminium, nitrogen, germanium, tin, bismuth or any combination thereof.

9. A solid-state structure according to claim 6, wherein the first semiconductor material is a compound comprising indium and arsenide.

10. A solid-state structure according to any one of claims 1-9, wherein the crystal structure of the second semiconductor material is mismatched with respect to the crystal structure of the first semiconductor material such that the lattice of the second crystal structure has at least one lattice parameter that is different from at least one lattice parameter of the lattice of the first crystal structure.

11. A solid-state structure according to claim 10, wherein the at least one lattice parameter of the lattice of the second crystal structure differs from the at least one lattice parameter of the lattice of the first crystal structure by between 2% and 10%.

12. A solid-state structure according to any one of claims 1-11, wherein said QD subjected to tensile strain is subjected to tensile strain in at least two directions relatively to at least a portion of the respective QD-carrier interface.

13. A solid-state structure according to any one of claims 1-12, wherein said QD subjected to tensile strain is subjected to tensile strain in at least two directions perpendicular to a longitudinal direction of the carrier.

14. A solid-state structure according to any one of claims 1-13, wherein said QD subjected to tensile strain is subjected to tensile strain in at least two directions perpendicular to a direction parallel to a crystallographic direction in which the carrier has been grown.

15. A photodetector (100) comprising a solid-state structure (105) according to any one of claims 1-14 for photodetection of radiation (140).
